# EUROPÄISCHE PATENTSCHRIFT

(11) **EP 1 849 017 B1**
(45) Veröffentlichungstag und Bekanntmachung des Hinweises auf die Patenterteilung: **22.12.2010**
(21) Anmeldenummer: 06708175.2
(22) Anmeldetag: 10.02.2006
(51) Int. Cl.: G01R 15/14, G01R 31/308

(54) **VERFAHREN ZUR ERMITTLUNG DER BELASTUNG EINES ELEKTRISCHEN LEITERS**
METHOD FOR DETERMINING THE LOAD OF AN ELECTRIC CONDUCTOR
PROCEDE DE DETERMINATION DE LA CHARGE D'UN CONDUCTEUR ELECTRIQUE

(30) Priorität: 15.02.2005 DE 102005007227
(43) Veröffentlichungstag der Anmeldung: 31.10.2007
(73) Patentinhaber: SIEMENS AKTIENGESELLSCHAFT, 80333 München (DE)
(72) Erfinder: SCHÖFFNER, Günther, 85080 Gaimersheim (DE)
(86) Internationale Anmeldenummer: PCT/EP2006/050832
(87) Internationale Veröffentlichungsnummer: WO 2006/087296

(56) Entgegenhaltungen:
- EP-A- 0 714 031
- EP-A- 0 984 289
- DE-A1-102004 016 602
- DE-U1- 9 011 023
- US-A- 5 214 595
- US-A- 5 804 972

## Beschreibung

Die Erfindung bezieht sich auf ein Verfahren zur Ermittlung der Belastung eines elektrischen Leiters zur Übertragung elektrischer Energie, der von einem Kapselungsgehäuse umgeben ist, welches eine Gasisolation begrenzt, wobei dem Leiter eine Empfangseinrichtung zum Empfangen einer elektromagnetischen Strahlung zugeordnet ist.

Eine Anordnung ist beispielsweise aus der veröffentlichen PCT-Anmeldung WO 1997/28591 bekannt. Dort sind in einer Gasisolation einer metallgekapselten Schaltanlage für Hoch- oder Mittelspannung Sensoren angeordnet. Die Sensoren dienen der Erfassung verschiedener physikalischer Größen wie beispielsweise einer Temperatur eines elektrischen Stromes oder auch einer Gasdichte. Auf den Innenraum ist eine Sende- und Empfangsantenne gerichtet. Über die Sende- und Empfangsantennen sind die im Innenraum angeordneten Sensoren ansprechbar. Der Informationsaustausch kann per Ultraschall, Infrarot oder bevorzugter Hochfrequenzübertragung erfolgen. Weiterhin kann vorgesehen sein, die auf den Innenraum gerichtete Sende- und Empfangsantenne außerhalb des Kapselungsgehäuses anzuordnen, wodurch eine gute Zugänglichkeit von außen möglich ist.

Die Anordnung von Sensoren im Innern des Kapselungsgehäuses stellt sich problematisch dar. So müssen die Sensoren zu ihrer Arbeit beispielsweise mit elektrischer Energie versorgt werden. Oftmals sind die Sensoren jedoch auf einem erhöhten Spannungspotential liegend angeordnet, so dass dies mit erheblichem Aufwand verbunden ist. Weiterhin wird durch das Einbringen von Sensoren das dielektrische Feld im Innern der metallgekapselten Schaltanlage gestört. So ist stets ein Kompromiss zu finden, zwischen einer kompakten, dielektrisch günstigen Ausgestaltung und einer hohen Leistungsfähigkeit der Sensoren.

Aus den Patentschriften US 5,804,972 sowie der europäischen Patentanmeldung EP 0 984 289 A1 sind jeweils Teilentladungsdetektoren bekannt, welche eine Empfangsantenne aufweisen, um die von Teilentladungen ausgehenden hochfrequenten Strahlungen zu empfangen. Die empfangene Strahlung bildet die Teilentladungen ab.

Weiterhin ist aus der europäischen Patentanmeldung EP 0 714 031 A1 ein Verfahren zur Kontaktdiagnose an Elektroanlagen bekannt. Das dort beschriebene Verfahren dient einer Ermittlung eines Widerstandes einer Verbindung eines elektrischen Leiters unter Nutzung von Infrarotmesstechnik.

Darüber hinaus ist aus dem deutschen Gebrauchsmuster DE 90 11 023 bekannt, einen innerhalb eines Gerätegehäuses befindlichen Gegenstand, beispielsweise einen Schalter oder einen Sammelschienenabzweig hinsichtlich seiner Temperatur zu überwachen. Dazu ist vorgesehen, durch eine Wand des Gerätegehäuses einen Lichtwellenleiter in die Nähe des zu überwachenden Gegenstandes zu führen und so die infrarote Strahlung in der Nähe des zu überwachenden Gegenstandes zu erfassen und mittels des Lichtwellenleiters zu einem Infrarottemperaturmessgerät hinzuleiten. Insbesondere bei Hochspannungen stellt ein derartig spitz auf den zu überwachenden Gegenstand ragender Lichtwellenleiter eine Inhomogenität innerhalb des den zu überwachenden Gegenstandes umgebenden Gas dar. Somit besteht bei der Verwendung eines Lichtwellenleiters in der bekannten Art die Gefahr, die Betriebssicherheit des zu überwachenden Gegenstandes zu beeinträchtigen.

Eine Aufgabe der Erfindung ist es, ein Verfahren zur Ermittlung der Belastung eines elektrischen Leiters zur Übertragung elektrischer Energie anzugeben, der von einem Kapselungsgehäuse umgeben ist, welches eine Gasisolation übergrenzt, wobei dem Leiter eine Empfangseinrichtungen zum Empfangen einer elektromagnetischen Strahlung zugeordnet ist, welches eine verbesserte Überwachung des Zustandes des elektrischen Leiters auch im Hochspannungsbereich ermöglicht.

Erfindungsgemäß wird die Aufgabe bei einem Verfahren der eingangs genannten Art dadurch gelöst, dass
- die Empfangsvorrichtung eine eine Temperatur des elektrischen Leiters abbildende elektromagnetische Strahlung empfängt,
- eine Temperatur des Kapselungsgehäuses ermittelt wird,
- die Temperaturen des elektrischen Leiters und des Kapselungsgehäuses abbildende Daten verarbeitet werden und
- in Abhängigkeit der verarbeiteten Daten ein Auslastungsgrad des elektrischen Leiters bestimmt wird.

Die zu wesentlichen Teilen aus dem elektrischen Leiter und dem den elektrischen Leiter umgebenden Kapselungsgehäuse gebildete Anlage wird von dem durch den elektrischen Leiter fließenden Strom von Innen erwärmt. Diese Temperatur soll möglichst rasch an die Umgebung abgegeben werden. Da eine Temperaturerhöhung eine Erhöhung des elektrischen Widerstandes des elektrischen Leiters bewirkt und so die Übertragungsverluste erhöht, ist eine rasche Wärmeabgabe nach außen von Interesse. Aus dem Verhältnis der Temperaturen des elektrischen Leiters und des Kapselungsgehäuses, insbesondere von deren zeitlicher Änderung, kann darauf geschlossen werden, ob es sich um eine lokale Temperaturerhöhung handelt, die aufgrund des Wärmeabstrahlverhaltens des Kapselungsgehäuses rasch abbaubar ist oder ob sich längs des gesamten Leiters eine Temperaturerhöhung einstellt, die die Betriebssicherheit des elektrischen Leiters gefährdet. Die über die Temperaturen von elektrischem Leiter und Kapselungsgehäuse gewonnenen Informationen in Form von Daten können weiterverarbeitet werden und Aussagen über die Belastbarkeit des elektrischen Leiters getroffen werden. Dabei können die Informationen über die Temperaturen auch im Zusammenhang weiterer Energieübertragungseinrichtungen, wie beispielsweise parallel liegenden Leitungen, Kabeln, Freileitungen oder ähnlichem bestimmt werden. Da sich gasisolierte Leitungen, die einen elektrischen Leiter im Innern eines Kapselungsgehäuses aufweisen gegenüber dem Kapselungsgehäuse mit einer Gasisolation isoliert ist, auch im Überlastbetrieb betreiben lassen, ohne dabei eine dauerhafte Schädigung zu erfahren, können derartige Energieübertragungseinrichtungen gezielt auch kurzzeitig in Überlast betrieben werden. Dadurch kann man beispielsweise Spitzenlasten innerhalb eines Energieübertragungsnetzes abfangen und so ein bestehendes Netz kostengünstig betrieben werden.

Die Verteilung von einer Vielzahl von Temperaturerfassungsstellen sowohl an dem elektrischen Leiter als auch an dem Kapselungsgehäuse gestattet einen zeitlichen sowie örtlichen Verlauf von Temperaturen zu erfassen. So können weiterhin gezielt thermische Schwachstellen, das heißt, Punkte die besonders häufig eine erhöhte Temperatur gegenüber weiteren Punkten aufweisen, identifiziert werden. So kann beispielsweise auch gezielt für Abhilfe gesorgt werden, um beispielsweise eine bessere Wärmeabfuhr über das Kapselungsgehäuse zu erzielen bzw. die Ursachen für eine erhöhte Temperatur, wie beispielsweise hohe Übergangswiderstände an Kontaktierungsbereichen verschiedener Abschnitte des elektrischen Leiters, behoben werden.

Zur elektromagnetischen Strahlung gehören neben der Wärmestrahlung unter anderem auch sichtbares Licht, Radiowellen und Röntgenstrahlung. Jeder Körper emittiert und absorbiert Strahlung. So auch ein elektrischer Leiter, insbesondere wenn er von einem elektrischen Strom durchflossen ist. Findet sich der elektrische Leiter in einem thermischen Gleichgewicht zu seiner Umgebung, so vollziehen sich Emission und Absorbtion mit gleicher Geschwindigkeit. Hat der Körper eine höhere Temperatur als seine Umgebung, so emittiert er mehr als er absorbiert. Dadurch kühlt er sich ab und erwärmt die Umgebung.

Durch eine Erfassung der von dem elektrischen Leiter ausgesandten elektromagnetischen Strahlung können Informationen über den Zustand des elektrischen Leiters gewonnen werden.

Zusätzliche Sensoren, die der Erfassung physikalischer Größen dienen, sind so nicht von Nöten, da der Körper des elektrischen Leiters selbst als Strahler wirkt.

Eine weitere vorteilhafte Ausgestaltung kann vorsehen, dass die elektromagnetische Strahlung infrarote Strahlung oder ultraviolette Strahlung oder sichtbare Strahlung ist.

Elektromagnetische Strahlung wird in Form elektronmagnetischer Wellen übertragen. Elektromagnetische Wellen treten als Radiowellen, Mikrowellen, Infrarotstrahlung, Ultraviolettstrahlung, sichtbares Licht, Röntgenstrahlung oder auch Gammastrahlung auf. Die verschiedenen Arten elektromagnetischer Strahlung unterscheiden sich durch ihre Frequenz bzw. ihre Wellenlänge. Der Wellenlängenbereich von 400 bis 800 nm wird als sichtbarer Spektralbereich bezeichnet. Der sich anschließende kleinere Wellenbereich wird als ultraviolette Strahlung mit einer Wellenlänge von 10 nm bis 400 nm bezeichnet. Der Infrarotbereich umfasst Wellenlängen von 800 nm bis 1 mm. Die Wärmestrahlung von Körpern bei gewöhnlicher Temperatur liegt im infraroten Bereich des elektromagnetischen Spektrums. Die infrarote Strahlung ist von besonderer Bedeutung bei einer Ermittlung der Belastung des elektrischen Leiters. Bei einem Stromfluss durch den elektrischen Leiter treten bedingt durch Stromwärmeeffekte Temperaturerhöhungen gegenüber der Umgebung auf. Der elektrische Leiter strahlt im infraroten Bereich und gibt infrarote Strahlung ab. Durch die Empfangsvorrichtung kann diese Strahlung erfasst werden und auf die Temperatur des Leiters geschlussfolgert werden, da bestimmten Strahlungsenergien bestimmten Temperaturen des elektrischen Leiters zugeordnet werden können.

Eine vorteilhafte Ausgestaltung kann weiter vorsehen, dass die Empfangseinrichtung zumindest teilweise innerhalb des Kapselungsgehäuses angeordnet ist.

Innerhalb des Kapselungsgehäuses ergeben sich oftmals fertigungsbedingt dielektrisch geschützte Räume bzw. Bereiche, welche nicht mit aktiven elektrischen Leitern befüllbar sind. In diesen Bereichen ist es möglich, zumindest Teile der Empfangseinrichtung unterzubringen. Bei einer Anordnung zumindest von Teilen der Empfangseinrichtung kann die Infrarotstrahlung unmittelbar von der Empfangseinrichtung erfasst werden. Atmosphärische Störungen sind so begrenzt, da durch das Kapselungsgehäuse ein Eindringen von Störgrößen in die Gasisolation zumindest teilweise verhindert werden kann. Zur Weiterverarbeitung der ermittelten Informationen können diese beispielsweise aus dem Innern des Kapselungsgehäuses durch dieses nach außen hin übertragen werden.

Dazu kann eine vorteilhafte Ausgestaltung vorteilhaft vorsehen, dass die Empfangseinrichtung zumindest teilweise außerhalb des Kapselungsgehäuses angeordnet ist.

Außerhalb des Gehäuses können beispielsweise elektronische Verarbeitungseinrichtungen angeordnet sein, welche gewonnene Informationen über die abgegebene elektromagnetische Strahlung des elektrischen Leiters weiterverarbeiten. Um die Übertragung von Informationen durch das Kapselungsgehäuse möglichst einfach zu ermöglichen, können dabei zumindest Teile der Empfangseinrichtung außerhalb des Kapselungsgehäuses angeordnet sein. So kann beispielsweise vorgesehen sein, dass an einem Flansch des Kapselungsgehäuses ein Flanschdeckel ansetzbar ist, welcher von der Empfangseinrichtung für die elektromagnetische Strahlung durchdrungen ist, so dass sich Teile der Empfangseinrichtung innerhalb des Kapselungsgehäuses und andere Teile außerhalb des Kapselungsgehäuses befinden. Durch eine geschickte Ausgestaltung des Flanschdeckels kann so auch eine gasdichte Abdichtung der Empfangseinrichtung in dem Flanschdeckel erfolgen. Durch diese kompakten Ausgestaltungen sind derartige Dichtungen dann beispielsweise vor mechanischen Beschädigungen gut geschützt. Weiterhin gestattet eine derartige Ausgestaltung auch an bestehenden Anlagen Empfangsvorrichtungen für elektromagnetische Strahlung nachträglich zu installieren. Es kann jedoch auch vorgesehen sein, die Empfangseinrichtung vollständig im Inneren des Kapselungsgehäuses anzuordnen oder auch vollständig außerhalb des Kapselungsgehäuses zu positionieren. Je nach vorhandener Anlage und nach vorhandenen Einbaureserven können sich so vorteilhafte Ausgestaltungen ergeben. Anlagen mit großen Reserven innerhalb der Gasisolation können die Empfangseinrichtung beispielsweise vollständig in ihrem Inneren aufnehmen. Für das Weiterleiten der Informationen können dann beispielsweise Datenkabel durch die Kapselungsgehäusewand hindurch nach außen geführt werden. Alternativ kann auch vorgesehen sein, eine drahtlose Übertragung aus dem Inneren des Kapselungsgehäuses nach außerhalb des Kapselungsgehäuses vorzusehen. Dazu können beispielsweise induktive Koppeleinrichtungen oder optische Koppeleinrichtungen genutzt werden.

Bei sehr kompakten Anlagen, deren Gasisolation den Einbau einer Empfangseinrichtung für elektromagnetische Strahlung nicht gestatten, kann diese auch vollständig außerhalb des Kapselungsgehäuses angeordnet werden. Diese Anordnung hat den Vorteil, dass sich eine Übertragung von Informationen durch die Kapselungsgehäusewand erübrigt.

Eine weitere vorteilhafte Ausgestaltung kann vorsehen, dass das Kapselungsgehäuse die Gasisolation gasdicht umschließt.

Gasdichte Kapselungsgehäuse werden eingesetzt, um ein Isoliergas von der Umgebung abzugrenzen. So können die Kapselungsgehäuse beispielsweise auch druckgasdicht ausgeführt werden und die Gasisolation im Inneren des Kapselungsgehäuses mit einem erhöhten Druck beaufschlagt werden.

Eine gasdichte Ausgestaltung eines Kapselungsgehäuses stellt hohe Anforderungen an vorzunehmende Abdichtungen, um einen Verlust von Isoliergas und damit eine Einschränkung der Isolationsfestigkeit der Gesamtanordnung zu verhindern. Es kann daher weiterhin vorteilhaft vorgesehen sein, dass die elektromagnetische Strahlung außerhalb des Kapselungsgehäuses erfasst wird.

Durch die Erfassung der Strahlung außerhalb des Kapselungsgehäuses kann auf die Übertragung von im Inneren des Kapselungsgehäuses erfassten Daten nach Außerhalb des Kapselungsgehäuses verzichtet werden. Dadurch sind gasdichte Durchführungen beziehungsweise drahtlose Übertragungseinrichtungen nicht nötig. Dadurch kann die Anordnung selbst einfacher ausgestaltet werden. Durch den Verzicht auf komplizierten Übertragungseinrichtungen wird die Gesamtanordnung kostengünstiger.

Eine weitere vorteilhafte Ausgestaltung kann vorsehen, dass das Kapselungsgehäuse eine Zone aufweist, die einen höheren spektralen Transmissionsgrad aufweist, als der sie umgebende Bereich.

Um Kapselungsgehäuse besonders druckfest zu gestalten, werden diese oftmals zu großen Teilen aus Metallen, wie beispielsweise aus Aluminium oder Stahl, gefertigt. Um eine ausreichende Druckfestigkeit zu erzielen, ist dabei die Stärke derartig groß, dass eine Übertragung von elektromagnetischer Strahlung durch die Kapselungsgehäusewandung hindurch mit größeren Verlusten verbunden ist. Vorteilhaft ist daher, das Kapselungsgehäuse mit einer besonderen Zone zu versehen, die einen für die durch die Wandung des Kapselungsgehäuses hindurch zu übertragende elektromagnetische Strahlung hohen spektralen Transmissionsgrad aufweist. Der Transmissionsgrad ist dabei durch den Quotienten aus durchgelassener Strahlungsleistung zu einfallender Strahlungsleistung bestimmt. Um eine ausreichende Übertragung zu gewährleisten, sollte der Transmissionsgrad der Zone einen Mindestwert von ca. 70 bis 75 % aufweisen. Bei einem Transmissionsgrad von 90 bis 95 % ist eine annähernd verlustfreie Übertragung elektromagnetischer Strahlung aus dem Innern des Kapselungsgehäuses nach außen hin erzielbar.

Vorteilhafterweise kann dabei vorgesehen sein, dass die Zone eine für die elektromagnetische Strahlung transparente Schmelze aufweist.

Eine transparente Schmelze gestattet in einfacher Weise die Transmission von elektromagnetischer Strahlung insbesondere von infraroter Strahlung. Je nach gewünschter zu übertragener elektromagnetischer Strahlung können geeignet Schmelzen ausgewählt werden, die für den jeweiligen elektromagnetischen Strahlungsbereich einen besonders geeigneten Transmissionsgrad aufweisen. Darüber hinaus kann die transparente Schmelze beispielsweise auch Filterfunktionen aufweisen, so dass bestimmte Strahlungsspektren absorbiert werden und nur die für den jeweiligen technischen Anwendungszweck relevante elektromagnetische Strahlung die transparente Schmelze passiert. Als transparente Schmelze sind beispielsweise verschiedene mineralische Gläser, Kunststoffe, Salze oder ähnliches einsetzbar.

Eine weitere vorteilhafte Ausgestaltung kann vorsehen, dass eine Temperatur des Kapselungsgehäuses mittels zumindest eines Sensors überwachbar ist.

Zur Erzielung einer ausreichenden Druckfestigkeit werden die Kapselungsgehäuse oftmals aus metallischen Rohren gebildet.

Diese Rohre können zum einen durch von dem elektrischen Leiter abgestrahlte Wärme erwärmt werden, zum anderen können über die Rohre zusätzliche Wärmemengen in das System eingetragen werden. Dies ist insbesondere dann der Fall, wenn Kapselungsgehäuse beispielsweise innerhalb geheizter Räumlichkeiten angeordnet sind oder einer Sonneneinstrahlungen ausgesetzt sind. Weiterhin kann über das Kapselungsgehäuse Wärme auch an die Umgebung abgegeben werden und so eine mittelbare Kühlung des elektrischen Leiters erfolgen. Da beispielsweise gasisolierte elektrische Leitungen zur Übertragung hoher Energiemengen über lange Streckenabschnitte bis zu mehreren 10 oder 100 km Länge einsetzbar sind, können längs des Verlegeweges die verschiedensten Temperaturverhältnisse auftreten. Beispielsweise kann an einzelnen Punkten starke Sonneneinstrahlung zu verzeichnen sein und an anderen Punkten, beispielsweise an einem unterirdisch verlegten Abschnitt kann eine gute Wärmeabgabe über die Kapselungsgehäusewandungen erfolgen. Die Belastbarkeit eines elektrischen Leiters ist im Wesentlichen durch seine Temperaturbeständigkeit begrenzt. Ein elektrischer Leiter darf sich daher nur so stark erwärmen, dass weder das elektrische Leitermaterial selbst, noch eingesetzte Isoliermittel beschädigt werden. Durch eine Überwachung der Temperatur des Kapselungsgehäuses ist die Möglichkeit gegeben , auf lokale Überhitzungen rasch zu reagieren und beispielsweise die zu übertragende Energiemenge zu reduzieren, um eine dauerhafte Schädigung des elektrischen Leiters des Kapselungsgehäuses oder der Gasisolation und weiterer Isolierelemente zu verhindern. Insbesondere bei einem Anordnen einer Vielzahl von Sensoren zur Überwachung der Temperatur des Kapselungsgehäuses längs des Verlegeweges, ist so eine zuverlässige Überwachung der Gesamtanordnung ermöglicht.

Sensoren sind dabei in vielfältigen Varianten einsetzbar. So können beispielsweise Thermoelemente oder temperaturabhängige Widerstände unmittelbar auf die Oberfläche des Kapselungsgehäuses aufgesetzt werden. Alternativ kann auch vorgesehen sein, Temperatursensoren beabstandet zur Oberfläche anzuordnen und berührungslos die Temperatur zu erfassen. Dies hat den Vorteil, dass die Sensoren selbst bei einer zu starken Überhitzung des Kapselungsgehäuses nicht beschädigt werden. Im Folgenden werden Ausführungsbeispiele der Erfindung schematisch in Figuren gezeigt und nachfolgend näher beschrieben.

Dabei zeigt die
- Figur 1: eine gasisolierte elektrische Leitung mit einem im Innern eines ersten Kapselungsgehäuses angeordne- ten ersten Infrarotsensor, die
- Figur 2: eine gasisolierte elektrische Leitung mit einem außerhalb eines zweiten Kapselungsgehäuses ange- ordneten zweiten Infrarotsensor, die
- Figur 3: eine gasisolierte elektrische Leitung mit einem außerhalb eines dritten Kapselungsgehäuses ange- ordneten dritten Infrarotsensor, die
- Figur 4: eine gasisolierte elektrische Leitung mit einem innerhalb und außerhalb eines vierten Kapselungs- gehäuses angeordneten vierten Infrarotsensor sowie einem ersten Temperatursensor, die
- Figur 5: eine gasisolierte elektrische Leitung mit einem fünften Infrarotsensor, der außerhalb eines fünf- ten Kapselungsgehäuses angeordnet ist sowie einem zweiten Sensor zur Erfassung der Temperatur des fünften Kapselungsgehäuses, und die
- Figur 6: ein sechstes Kapselungsgehäuse mit mehreren Mess- stellen zur Erfassung der elektromagnetischen Strahlung an einem elektrischen Leiter sowie meh- rere Sensoren zur Erfassung der Temperatur des sechsten Kapselungsgehäuses.

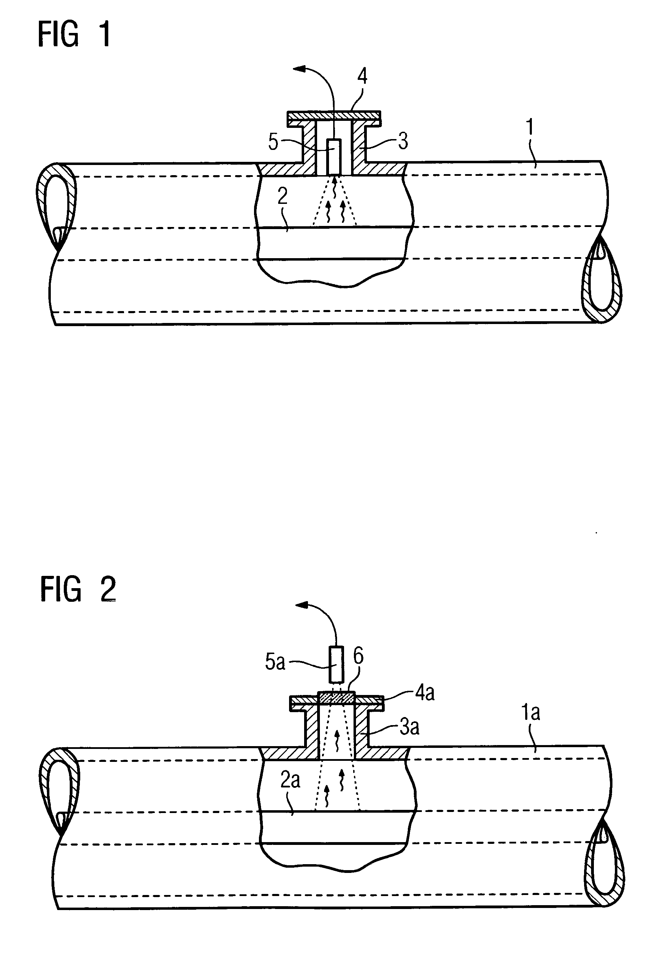

Beispielhaft wird anhand der Figur 1 zunächst der Aufbau einer gasisolierten elektrischen Leitung beschrieben. Die Figuren 2, 3, 4, 5 und 6 weisen in den dort dargestellten gasisolierten elektrischen Leitungen einen gleichartigen Aufbau auf.

Die Figur 1 weist ein erstes Kapselungsgehäuse 1 auf. Das erste Kapselungsgehäuse 1 ist im Wesentlichen rohrförmig ausgebildet und besteht aus einem metallischen Werkstoff wie beispielsweise Aluminium oder Stahl. Das erste Kapselungsgehäuse 1 ist gasdicht ausgeführt und schließt in seinem Inneren ein Isoliergas, beispielsweise Schwefelhexafluorid oder Stickstoff ein. Das im Innern des ersten Kapselungsgehäuses 1 eingeschlossene Gas weist einen erhöhten Druck auf. Zentrisch im Innern des ersten Kapselungsgehäuses 1 ist ein erster elektrischer Leiter 2 angeordnet. Der erste elektrische Leiter ist mittels Stützisolatoren (nicht dargestellt) zentrisch im Innern des ersten Kapselungsgehäuses gehalten.

Das erste Kapselungsgehäuse 1 sowie der erste elektrische Leiter 2 können beispielsweise Teil einer gasisolierten elektrischen Leitung sein. Derartige Anordnungen werden zur Übertragung von hohen Energiemengen über lange Streckenabschnitte eingesetzt. Es kann jedoch auch vorgesehen sein, dass das erste Kapselungsgehäuse 1 sowie der erste elektrische Leiter 2 Teil einer gasisolierten Schaltanlage sind.

Das erste Kapselungsgehäuse 1 weist an einer Mantelfläche einen ersten Anschlussflansch 3 auf. Der erste Anschlussflansch 3 ist mit einem ersten Flanschdeckel 4 verschlossen. Der erste Anschlussflansch 3 bildet einen dielektrisch geschützten Raum, das heißt, in diesem Raum sind problemlos Einbauten unterzubringen, ohne die Isolationsfestigkeit im Innern des ersten Kapselungsgehäuses 1 zu beeinträchtigen. Im Innern des ersten Anschlussflansches 3 ist ein erster Infrarotsensor 5 angeordnet. Der erste Infrarotsensor 5 ist beispielsweise eine Infrarotkamera, deren Erfassungsbereich auf den ersten elektrischen Leiter 2 gerichtet ist. Durch den ersten Flanschdeckel 4 ist eine Datenleitung gasdicht hindurchgeführt, um die von dem ersten Infrarotsensor 5 gelieferten Daten durch die Wandung des ersten Kapselungsgehäuses 1 hindurch zu übertragen. Alternativ kann auch vorgesehen sein, eine drahtlose Übertragung von Informationen aus dem Innern des ersten Kapselungsgehäuses durch die Wandung des ersten Kapselungsgehäuses 1 hindurch zu realisieren. Dazu können beispielsweise induktive Kopplungen, Funkkopplungen oder auch optische Übertragungsstrecken eingesetzt werden.

Der erste Infrarotsensor 5 ist auf einen Abschnitt des ersten elektrischen Leiters 2 ausgerichtet. Die von dem ersten elektrischen Leiter 2 abgegebene elektromagnetische Strahlung, in diesem Falle Infrarotstrahlung, wird von dem ersten Infrarotsensor 5 erfasst und in ein elektronisch verarbeitbares Datenformat umgesetzt. In Abhängigkeit der Intensität der von dem ersten elektrischen Leiter 2 ausgesandten Strahlung sind Rückschlüsse über auf die Temperatur des elektrischen Leiters 2 möglich.

Im Folgenden werden weitere Ausgestaltungsvarianten der Überwachung der Temperatur eines elektrischen Leiters angegeben. Dabei gelten die vorstehend getätigten Ausführungen sinngemäß auch für die nachfolgenden Ausgestaltungsbeispiele.

Die Figur 2 zeigt ein zweites Kapselungsgehäuse 1a sowie einen zweiten elektrischen Leiter 2a. An dem zweiten Kapselungsgehäuse 1a ist ein zweiter Anschlussflansch 3a angeordnet. Der zweite Anschlussflansch 3a ist mit einem zweiten Flanschdeckel 4a verschlossen. Der zweite Flanschdeckel 4a ist mit einem ersten Schauglas 6 versehen. Das erste Schauglas 6 dient als Zone, die für elektromagnetische Strahlung transparent ist. Das erste Schauglas 6 ist beispielsweise aus einem mineralischen Glas oder einem Kunststoff gefertigt und gasdicht in den zweiten Flanschdeckel 4a eingesetzt. Außerhalb des zweiten Kapselungsgehäuses 2a ist ein zweiter Infrarotsensor 5a angeordnet. Der zweite Infrarotsensor 5a ist durch das erste Schauglas 6 hindurch auf den zweiten elektrischen Leiter 2a ausgerichtet und erfasst die von dem zweiten elektrischen Leiter 2a ausgehende Infrarotstrahlung, welche auch durch das erste Schauglas 6 hindurchtritt. Das erste Schauglas 6 weist eine 90 bis 95%ige Transmissionsgrad für infrarote Strahlung auf.

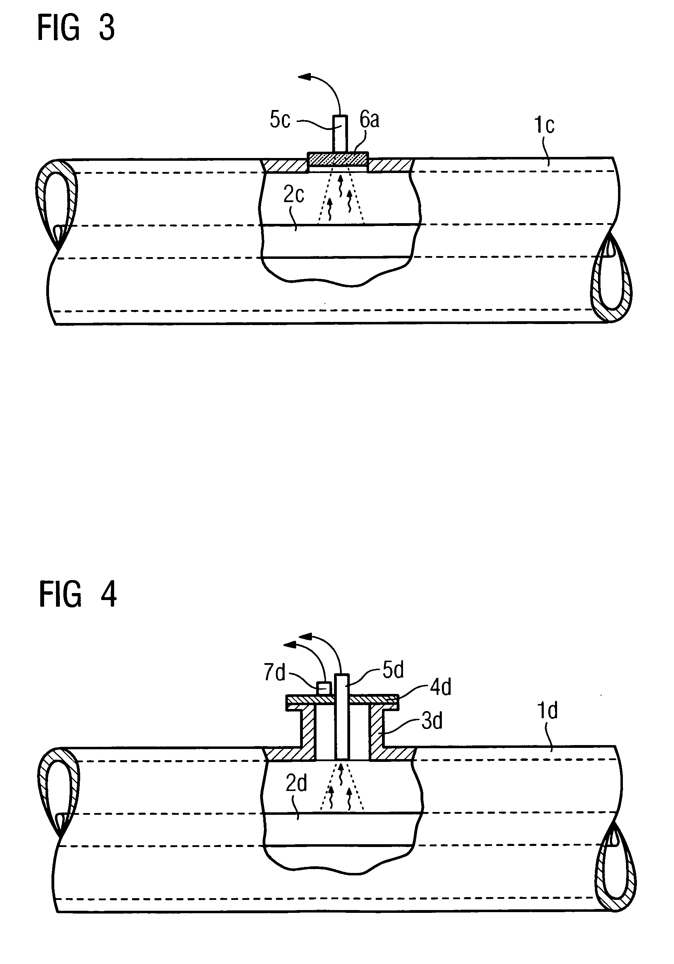

In der Figur 3 ist ein drittes Kapselungsgehäuse 1c sowie ein dritter elektrischer Leiter 2c dargestellt. Das dritte Kapselungsgehäuse 1c weist in seiner Mantelfläche eine Ausnehmung auf, in die zweites Schauglas 6a gasdicht eingelassen ist. Ein dritter Infrarotsensor 5c ist unmittelbar auf das zweite Schauglas 6a aufgesetzt. Dadurch ist das Eindringen von Störstrahlung aus der Umgebung des dritten Kapselungsgehäuses 1c vermindert.

Die Figur 4 zeigt ein viertes Kapselungsgehäuse 1d. Im Innern des vierten Kapselungsgehäuses 1d ist ein vierter elektrischer Leiter 2d angeordnet. Im Mantelbereich des vierten Kapselungsgehäuses 1d ist ein vierter Anschlussflansch 3d angeordnet. Der vierte Anschlussflansch 3d ist durch einen vierten Flanschdeckel 4d verschlossen. Der vierte Flanschdeckel 4d ist dabei derart ausgeführt, dass ein vierter Infrarotsensor 5d teilweise innerhalb der Kapselung des vierten Kapselungsgehäuses 1d und teilweise außerhalb des vierten Kapselungsgehäuses 1d angeordnet ist. Zusätzlich ist auf den vierten Flanschdeckel 4d ein erster Temperatursensor 7d befestigt. Mittels des ersten Temperatursensors 7d ist die Temperatur des vierten Kapselungsgehäuses 1d erfassbar. Der erste Temperatursensor 7d ist als temperaturabhängiges Widerstandselement ausgebildet. Der fünfte Infrarotsensor 5d erfasst die von dem vierten elektrischen Leiter 2d ausgehende Infrarotstrahlung.

Bei einer Anordnung eines Infrarotsensors und eines Temperatursensors gemeinsam an einem Flanschdeckel besteht die Möglichkeit, diese in einfacher Weise in einer bestehenden Anlage nachzurüsten. So können beispielsweise vorhandene Mannlöcher bzw. Montagelöcher genutzt werden, um eine Überwachung eines elektrischen Leiters bzw. eines Kapselungsgehäuses vorzunehmen. Weiterhin ist durch eine derartige Anordnung eine leichte Austauschbarkeit sowie Reparatur von defekten Infrarotsensoren bzw. Temperatursensoren gegeben, da diese rasch inklusive Flanschdeckel ausgetauscht werden können.

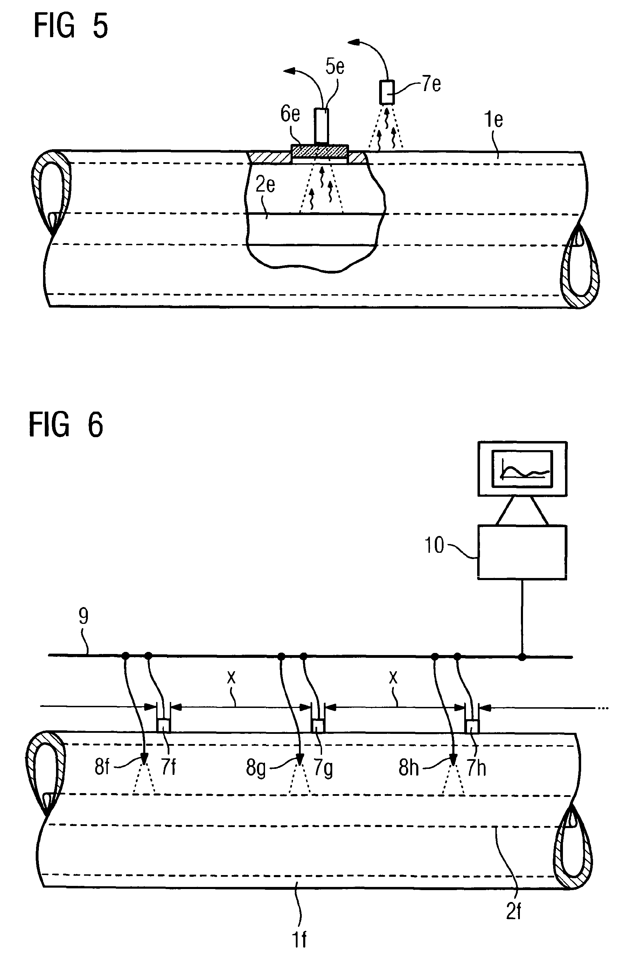

In der Figur 5 ist ein fünftes Kapselungsgehäuse 1e dargestellt. Im Innern des fünften Kapselungsgehäuses 1e ist ein fünfter elektrischer Leiter 2e angeordnet. In der Mantelfläche des fünften Kapselungsgehäuses 1e ist ein drittes Schauglas 6e gasdicht eingefügt. Wie zur Figur 3 beschrieben, ist ein fünfter Infrarotsensor 5e unmittelbar auf das dritte Schauglas 6e aufgesetzt und erfasst durch das dritte Schauglas 6e die von dem fünften elektrischen Leiter 2e ausgesandte Infrarotstrahlung.

Zur Überwachung der Temperatur des fünften Kapselungsgehäuses 1e ist ein weiterer Infrarotsensor 7e genutzt, welcher die von dem fünften Kapselungsgehäuse 1e ausgesandte Infrarotstrahlung erfasst und die Temperatur des fünften Kapselungsgehäuses 1e abbildet.

In der Figur 6 ist prinzipiell das Zusammenwirken mehrerer Infrarotsensoren, die längs eines elektrischen Leiters verteilt angeordnet sind, sowie mehrerer Sensoren zur Erfassung der Temperatur eines Kapselungsgehäuses, die längs des Kapselungsgehäuses verteilt angeordnet sind, dargestellt.

An einem sechsten Kapselungsgehäuse 1f sind weitere Temperatursensoren 7fgh verteilt angeordnet. Weiterhin sind weitere Infrarotsensoren 8f,g,h zur Überwachung eines sechsten elektrischen Leiters 2f, der sich im Innern des sechsten Kapselungsgehäuses 1f befindet, eingesetzt. Jeder der weiteren Infrarotsensoren 8f,g,h ist jeweils ein weiterer Temperatursensor 7f,g,h zur Überwachung der Temperatur des sechsten Kapselungsgehäuses 1f zugeordnet. Von dieser unmittelbaren Zuordnung kann jedoch auch abgewichen werden und je nach Bedarf eine größere oder geringere Anzahl von Temperatursensoren eingesetzt werden.

Die weiteren Infrarotsensoren 8f,g,h sowie die weiteren Temperatursensoren 7f,g,h zur Erfassung der Temperatur des sechsten Kapselungsgehäuses 1f sind in gleichmäßigen Abständen X längs des Verlegeweges des sechsten elektrischen Leiters 2f verteilt angeordnet.

Die von den weiteren Temperatursensoren 7f,g,h und den weiteren Infrarotsensoren 8f,g,h erfassten Informationen werden auf eine Busleitung 9 übertragen. Mittels der Busleitung 9 werden die Informationen beispielsweise in eine Leitzentrale transferiert und dort ausgewertet. In der Leitzentrale ist eine Erfassungs- und Auswerteeinrichtung 10 angeordnet. In Abhängigkeit der zeitlichen Änderung sowie der örtlichen Lage der sich ändernden Temperaturen an dem sechsten Kapselungsgehäuse 1f bzw. des sechsten elektrischen Leiters 2f sind Informationen über eine mögliche Überlastung bzw. mögliche Reserven des sechsten elektrischen Leiters 2f ermittelbar. Aus den abweichenden Temperaturverläufen längs des sechsten elektrischen Leiters 2f sowie längs des sechsten Kapselungsgehäuses 1f können dann Rückschlüsse darüber gezogen werden, wie die Wärme aus dem Inneren der gasisolierten elektrischen Leitung in die Umgebung abgegeben wird oder ob beispielsweise ein außerhalb des Kapselungsgehäuses auftretendes Ereignis eine Temperaturerhöhung im Innern des Kapselungsgehäuses bewirkt.

In der Leitwarte kann in Abhängigkeit dieser Informationen dann eine Entscheidung über eine mögliche Erhöhung der Strombelastung bzw. über eine Minderung der Strombelastung des sechsten elektrischen Leiters 2f entschieden werden. Dazu kann vorgesehen sein, dass beispielsweise die dem elektrischen Leiter bzw. von dem Kapselungsgehäuse zugeordneten Temperatursensoren gelieferten Daten in einem neuronalen Netz verarbeitet werden und ein Vorschlag zur Optimierung der Belastungssituation gegeben wird. Ein neuronales Netz bietet den Vorteil, dass mit zunehmender Betriebserfahrung eine große Anzahl typischer Temperaturverläufe erfasst wurden und daraus folgend Vorhersagen zu vorliegenden Situationen getroffen werden können.

Die in den einzelnen Figuren 1,2,3,4,5 und 6 dargestellten Ausgestaltungsvarianten von Sensoren und deren Anordnung sind untereinander kombinierbar.

## Patentansprüche

1. Verfahren zur Ermittlung der Belastung eines elektrischen Leiters (2f) zur Übertragung elektrischer Energie, der von einem Kapselungsgehäuse (1f) umgeben ist, welches eine Gasisolation begrenzt, wobei dem Leiter (2f) eine Empfangseinrichtung (8f, 8g, 8h) zum Empfangen einer elektromagnetischen Strahlung zugeordnet ist,
**dadurch gekennzeichnet, dass**
- die Empfangsvorrichtung (8f, 8g, 8h) eine eine Temperatur des elektrischen Leiters abbildende elektromagnetische Strahlung empfängt,
- eine Temperatur des Kapselungsgehäuses (1f) ermittelt wird,
- die Temperaturen des elektrischen Leiters (2f) und des Kapselungsgehäuses (1f) abbildende Daten verarbeitet werden und
- in Abhängigkeit der verarbeiteten Daten ein Auslastungsgrad des elektrischen Leiters (2f) bestimmt wird.

## Claims

1. Method for determining the load on an electrical conductor (2f) for transmission of electrical power, which conductor (2f) is surrounded by an encapsulating housing (1f) which bounds gas insulation, wherein the conductor (2f) is associated with a receiving device (8f, 8g, 8h) for receiving electromagnetic radiation,
**characterized in that**
- the receiving device (8f, 8g, 8h) receives electromagnetic radiation which images a temperature of the electrical conductor,
- a temperature of the encapsulating housing (1f) is determined,
- data which images the temperatures of the electrical conductor (2f) and of the encapsulating housing (1f) is processed, and
- a load level on the electrical conductor (2f) is determined as a function of the processed data.

## Revendications

1. Procédé de détermination de la charge d'un conducteur ( 2f ) électrique de transport d'énergie électrique, qui est entouré d'une enveloppe ( 1f ) blindée délimitant une isolation par du gaz, dans lequel on associe au conducteur ( 2f ) un dispositif ( 8f, 8g, 8h ) de réception d'un rayonnement électromagnétique,
**caractérisé en ce que**
- le dispositif ( 8f, 8g, 8h ) de réception reçoit un rayonnement électromagnétique représentant une température du conducteur électrique,
- on détermine une température de l'enveloppe ( 1f ) de blindage,
- on traite des données représentant les températures du conducteur ( 2f ) électrique et de l'enveloppe ( 1f ) de blindage, et
- en fonction des données traitées, on détermine un pourcentage d'utilisation du conducteur ( 2f ) électrique.
